# EUROPEAN PATENT APPLICATION

(11) **EP 4 672 945 A1**
(43) Date of publication of application: **31.12.2025**
(21) Application number: 25185534.2
(22) Date of filing: 26.06.2025
(51) Int. Cl.: H10K 59/80, H10K 50/11

(54) **DAM STRUCTURE, DISPLAY DEVICE HAVING THE SAME AND ELECTRONIC DEVICE INCLUDING THE SAME**

(30) Priority: 26.06.2024 KR 20240084022; 04.07.2024 KR 20240088272
(71) Applicant: Samsung Display Co., Ltd., Yongin-si, Gyeonggi-do 17113 (KR)
(72) Inventor: KIM, Hyun, Yongin-si (KR); LEE, Seungmin, Yongin-si (KR)
(74) Representative: Marks & Clerk LLP

(57) **Abstract**

A display device includes a base substrate including a display area and a peripheral area adjacent to each other, on the base substrate, each of first and second light-emitting elements in the display area and respectively including first and second light-emitting layers, a dam structure which extends continuously in the peripheral area and includes first and second sub-dams, a first light-emitting material layer including the first light-emitting layer and the first sub-dam, and a second light-emitting material layer including the second light-emitting layer and the second sub-dam, an encapsulation substrate facing the base substrate with each of the first and second light-emitting elements and the dam structure therebetween, and a filling layer between the encapsulation substrate, and each of the first light-emitting element and the second light-emitting element, respectively.

## Description

### BACKGROUND

### 1. Field

Embodiments relate to a display device, and an electronic device including the same. More particularly, embodiments relate to a display device which provides visual information, and an electronic device including the same.

### 2. Description of the Related Art

If impurities such as moisture or oxygen enter a display device from outside thereof, the lifespan of a driving element included in the display device may be shortened and the luminous efficiency of a light-emitting element in the display device may decrease.

Accordingly, the display device may be encapsulated to prevent impurities such as moisture from penetrating into elements like the driving element and the light-emitting element. For example, the display device may include an encapsulation substrate forming a cover or cap to protect the elements.

### SUMMARY

Embodiments provide a display device with improved display quality.

Embodiments provide an electronic device including the display device.

A display device according to embodiments of the present disclosure includes a base substrate, a first light-emitting element disposed in a display area on the base substrate and including a first pixel electrode and a first light-emitting layer on the first pixel electrode, a second light-emitting element disposed in the display area on the base substrate and including a second pixel electrode and a second light-emitting layer on the second pixel electrode, a dam structure disposed in a peripheral area surrounding the display area and including a first sub-dam including a same material as the first light-emitting layer and a second sub-dam including a same material as the second light-emitting layer and disposed on the first sub-dam, an encapsulation substrate disposed on the first light-emitting element, the second light-emitting element, and the dam structure, and a filling layer disposed between the base substrate and the encapsulation substrate.

In an embodiment, each of the first light-emitting layer and the first sub-dam may include a first light-emitting material which emits a light of a first color, and each of the second light-emitting layer and the second sub-dam may include a second light-emitting material which emits a light of a second color different from the first color.

In an embodiment, the first sub-dam the second sub-dam may overlap in a plan view.

In an embodiment, the second sub-dam may be directly disposed on the first sub-dam.

In an embodiment, the dam structure may surround the display area in a plan view.

In an embodiment, the first sub-dam may have an open ring shape with at least a portion cut off to define a first open portion, and the second sub-dam may have an open ring shape with at least a portion cut off to define a second open portion.

In an embodiment, the first open portion and the second open portion may be spaced apart from each other in a plan view.

In an embodiment, the second open portion may expose a portion of the first sub-dam.

In an embodiment, the second sub-dam may be disposed within the first open portion and includes a connection portion connecting both sides of the first sub-dam defining the first open portion.

In an embodiment, a thickness of the first sub-dam may be a same as a thickness of the first light-emitting layer, and a thickness of the second sub-dam may be a same as a thickness of the second light-emitting layer.

In an embodiment, the display device may further include a sealing member which couples the base substrate and the encapsulation substrate between the base substrate and the encapsulation substrate. The sealing member may surround the dam structure in a plan view.

In an embodiment, the display device may further include an insulating layer disposed immediately under the first pixel electrode and the second pixel electrode and a pixel defining layer disposed on the insulating layer, the first pixel electrode, and the second pixel electrode and defining a pixel opening exposing a portion of the first pixel electrode and a portion of the second pixel electrode. The dam structure may be directly disposed on an upper surface of the insulating layer or an upper surface of the pixel defining layer.

In an embodiment, the dam structure may surround the filling layer in a plan view.

In an embodiment, the filling layer may cover the dam structure.

In an embodiment, the encapsulation substrate may include glass.

A display device according to embodiments of the present disclosure includes a base substrate, a first light-emitting layer disposed in a display area on the base substrate and including a first light-emitting material which emits a light of a first color, a second light-emitting layer disposed in the display area on the base substrate and including a second light-emitting material which emits a light of a second color different from the first color, a third light-emitting layer disposed in the display area on the base substrate and including a third light-emitting material which emits a light of a third color different from the first color and the second color, a dam structure disposed in a peripheral area surrounding the display area and including a first sub-dam including the first light-emitting material, a second sub-dam including the second light-emitting material and disposed on the first sub-dam, and a third sub-dam including the third light-emitting material and disposed on the second sub-dam, an encapsulation substrate disposed on the first light-emitting layer, the second light-emitting layer, the third light-emitting layer, and the dam structure, and a filling layer disposed between the base substrate and the encapsulation substrate.

In an embodiment, the first sub-dam, the second sub-dam, and the third sub-dam may overlap each other in a plan view.

In an embodiment, the second sub-dam may be directly disposed on the first sub-dam and the third sub-dam may be directly disposed on the second sub-dam.

In an embodiment, the dam structure may surround the display area in a plan view.

In an embodiment, the first sub-dam may have an open ring shape with at least a portion cut off to define a first open portion, the second sub-dam may have an open ring shape with at least a portion cut off to define a second open portion, and the third sub-dam may have an open ring shape with at least a portion cut off to define a third open portion.

In an embodiment, the first open portion, the second open portion, and the third open portion may be spaced apart from each other in a plan view.

In an embodiment, the second open portion may expose a portion of the first sub-dam, and the third open portion may expose a portion of the second sub-dam.

In an embodiment, the second sub-dam may be disposed within the first open portion and includes a first connection portion connecting both sides of the first sub-dam defining the first open portion, and the third sub-dam may be disposed within the second open portion and includes a second connection portion connecting both sides of the second sub-dam defining the second open portion.

In an embodiment, the second connection portion of the third sub-dam may be directly disposed on the first sub-dam exposed by the second open portion, and another portion of the third sub-dam may be directly disposed on the first connection portion of the second sub-dam.

In an embodiment, a thickness of the first sub-dam may be a same as a thickness of the first light-emitting layer, a thickness of the second sub-dam may be a same as a thickness of the second light-emitting layer, and a thickness of the third sub-dam may be a same as a thickness of the third light-emitting layer.

An electronic device according to embodiments of the present disclosure includes a display device and a processor which controls the display device. The display device includes a base substrate, a first light-emitting element disposed in a display area on the base substrate and including a first pixel electrode and a first light-emitting layer on the first pixel electrode, a second light-emitting element disposed in the display area on the base substrate and including a second pixel electrode and a second light-emitting layer on the second pixel electrode, a dam structure disposed in a peripheral area surrounding the display area and including a first sub-dam including a same material as the first light-emitting layer and a second sub-dam including a same material as the second light-emitting layer and disposed on the first sub-dam, an encapsulation substrate disposed on the first light-emitting element, the second light-emitting element, and the dam structure, and a filling layer disposed between the base substrate and the encapsulation substrate.

At least some of the above and other features of the invention are set out in the claims.

A display device according to embodiments of the present disclosure may include a base substrate, a first light-emitting layer disposed on the base substrate and including a first light-emitting material which emits a light of a first color and disposed on the base substrate, a second light-emitting layer including a second light-emitting material which emits a light of a second color different from the first color and disposed on the base substrate, an encapsulation substrate facing the base substrate, a filling layer disposed between the base substrate and the encapsulation substrate, and a dam structure disposed between the base substrate and encapsulation substrate.

In addition, the dam structure may have a structure in which a first sub-dam including the first light-emitting material and a second sub-dam including the second light-emitting material are stacked. For example, the first sub-dam may be formed in the same process as the first light-emitting layer, and the second sub-dam may be formed in the same process as the second light-emitting layer.

Accordingly, the dam structure may have a sufficient thickness, and a space where the filling layer is formed between the base substrate and the encapsulation substrate may be reduced by the dam structure. That is, the amount of filling material for forming the filling layer may be reduced. Accordingly, the generation of bubbles due to shrinkage of the filling material may be reduced or prevented. Accordingly, the display quality of the display device may be improved.

In addition, as the dam structure has a multi-layer structure in which sub-dams including light-emitting materials which emit light of different colors are stacked, the dam structure may reduce or prevent circuit structures such as lines, driving circuits, and the like disposed in a peripheral area on the base substrate from being visible from the outside. Accordingly, the display quality of the display device may be improved.

### BRIEF DESCRIPTION OF THE DRAWINGS

Illustrative, non-limiting embodiments will be more clearly understood from the following detailed description in conjunction with the accompanying drawings.
FIG. 1 is a plan view showing a display device according to an embodiment of the present disclosure.
FIG. 2 is a cross-sectional view taken along line I-I' of FIG. 1.
FIG. 3 is an enlarged view showing an enlarged example of the area AA of FIG. 2.
FIGS. 4, 5, 6, 7A, 7B, 8, 9, 10A, 10B and 10C are views for explaining a dam structure of FIG. 3.
FIGS. 11, 12, 13, 14, and 15 are cross-sectional views showing various enlarged examples of the area AA of FIG. 2.
FIG. 16 is a block diagram showing an electronic device according to an embodiment of the present disclosure.
FIG. 17 is a view illustrating an example of the electronic device of FIG. 16 implemented as a smartphone.

### DETAILED DESCRIPTION

Hereinafter, embodiments of the present disclosure will be explained in detail with reference to the accompanying drawings. The same reference numerals are used for the same components in the drawings, and redundant descriptions of the same components will be omitted.

It will be understood that when an element is referred to as being related to another element such as being "on" another element, it can be directly on the other element or intervening elements may be present therebetween. In contrast, when an element is referred to as being related to another element such as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

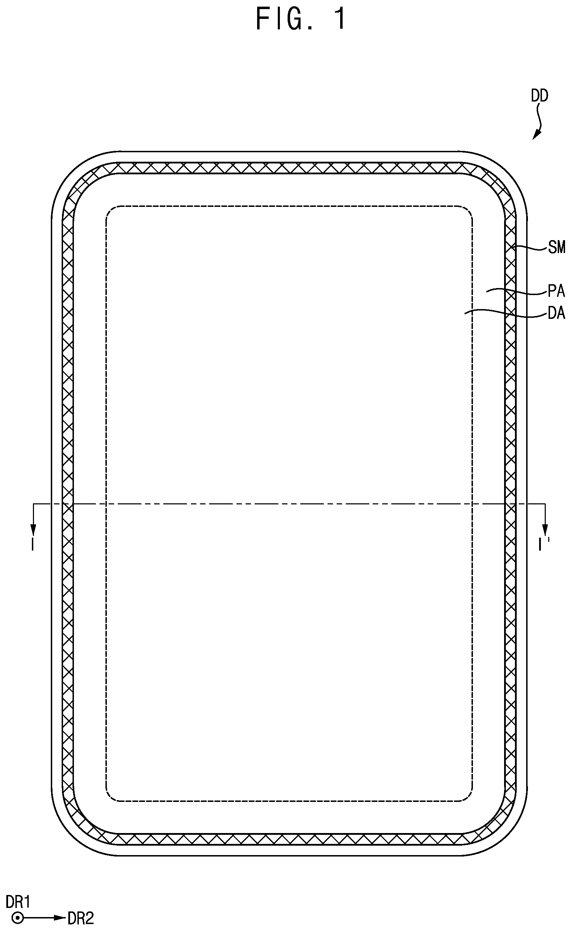

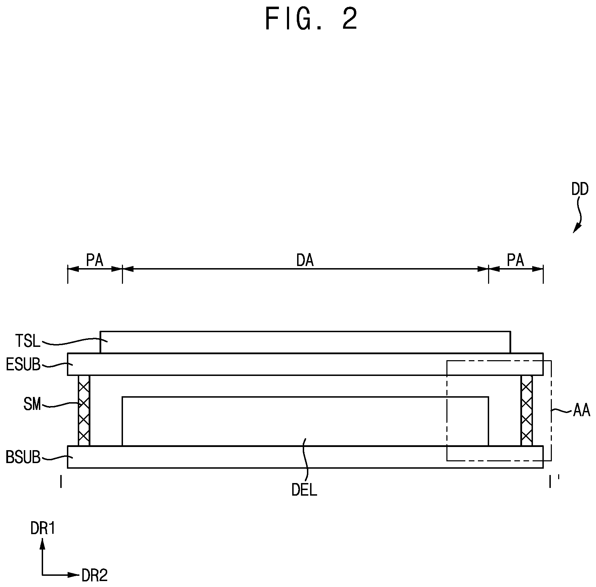

FIG. 1 is a plan view showing a display device DD according to an embodiment of the present disclosure. FIG. 2 is a cross-sectional view taken along line I-I' of FIG. 1.

Referring to FIGS. 1 and 2, a display device DD may include a display area DA and a peripheral area PA. The display area DA may be an area at which light is generated or an image is displayed, such as by adjusting the transmittance of light provided from an external light source. The peripheral area PA may be an area (e.g., a planar area) which does not display images (e.g., a non-display area). The peripheral area PA may be adjacent to the display area DA, such as to be located around the display area DA. For example, an entirety of the display area DA may be surrounded by the peripheral area PA.

The display device DD may include a base substrate BSUB, a display element layer DEL, an encapsulation substrate ESUB, a touch sensing layer TSL, and a sealing member SM.

The base substrate BSUB may serve as a base layer for the display device DD. In an embodiment, examples of materials which can be used as the base substrate BSUB may include glass, quartz, plastic, and the like. These can be used alone or in combination with each other.

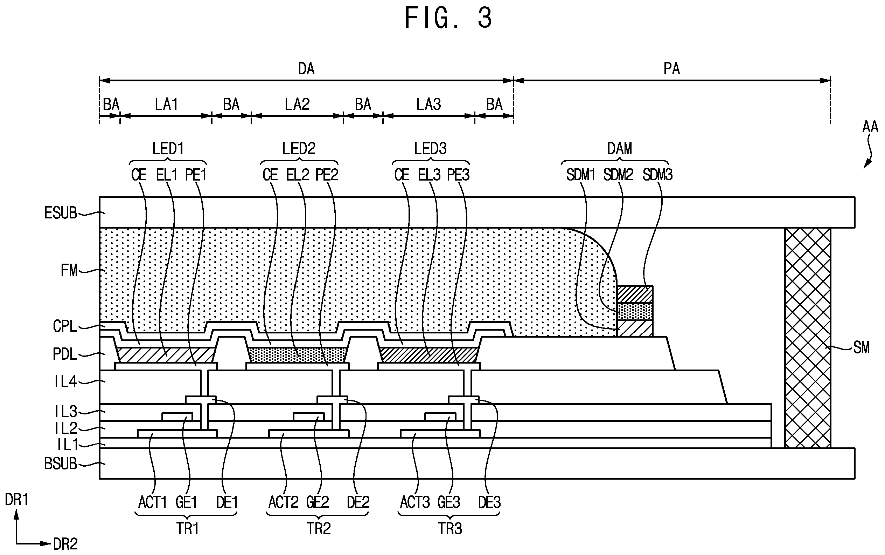

The display element layer DEL may be disposed on one side (or major surface) of the base substrate BSUB. The display element layer DEL may include light-emitting elements, driving elements which drive the light-emitting elements, a plurality of signal lines electrically connected to the driving elements and/or the light-emitting elements, and insulating layers insulating some of the aforementioned elements. The light-emitting elements may be connected (e.g., electrically connected) to the driving elements such that the light-emitting elements may be driven by the driving elements to emit light, display an image, etc. Accordingly, the display element layer DEL may generate and/or emit light. A specific structure of the display element layer DEL will be described in more detail later with reference to FIG. 3.

The encapsulation substrate ESUB may face the base substrate BSUB and may be located in a first direction DR1 from the base substrate BSUB toward the front of the display device DD. A thickness of the display device DD and various components or layers thereof may be defined along the first direction DR1, without being limited thereto. The display device DD and various components or layers thereof may be disposed parallel to a plane defined by two directions crossing each other, like a second direction DR2 and a third direction intersecting each of the first direction DR1 and the second direction DR2.

The encapsulation substrate ESUB may be disposed on the display element layer DEL. The encapsulation substrate ESUB may protect the display element layer DEL. For example, the encapsulation substrate ESUB may isolate an inner area at the inside of the display device DD from the outside thereof, and prevent impurities such as moisture from penetrating. In an embodiment, the encapsulation substrate ESUB may include glass.

The touch sensing layer TSL may be disposed on the encapsulation substrate ESUB. The touch sensing layer TSL may include a plurality of touch electrode arrays for detecting an external input in a capacitive method, a touch pad portion, and a plurality of touch lines electrically connecting the touch pad portion and the touch electrode arrays. For example, the touch sensing layer TSL may detect the external input from an input tool such as a user's body part or a touch, using a self-capacitance method or a mutual capacitance method. However, embodiments of the present disclosure are not limited thereto. Meanwhile, in an embodiment, the touch sensing layer TSL may be omitted.

The sealing member SM may couple the base substrate BSUB and the encapsulation substrate ESUB to each other. The sealing member SM may be disposed in the peripheral area PA, between the base substrate BSUB and the encapsulation substrate ESUB. The sealing member SM may have a closed-loop shape in the plan view. The inside of the display device DD may be defined by the base substrate BSUB together with the encapsulation substrate ESUB and the sealing member SM.

The sealing member SM may be disposed in the peripheral area PA, between the base substrate BSUB and the encapsulation substrate ESUB, to surround the display area DA in a plan view (e.g., a view along the first direction DR1 or a view of the plane defined by the two directions crossing each other). The sealing member SM may include a frit adhesive layer, an ultraviolet curable resin, and/or a thermosetting resin. However, embodiments of the present disclosure are not limited thereto.

FIG. 3 is an enlarged view showing an example of the area AA of FIG. 2.

Referring to FIGS. 1, 2, and 3, the display area DA may include a light-emitting area and a light-blocking area BA. Light generated and incident on the encapsulation substrate ESUB may be emitted to the outside (e.g., outside of the display device DD) through the light-emitting area. The light-emitting area may be provided in plural in light-emitting areas including first, second, and third light-emitting areas LA1, LA2, and LA3 for emitting light of different colors. For example, the first light-emitting area LA1 may emit a red light, the second light-emitting area LA2 may emit a green light, and the third light-emitting area LA3 may emit a blue light.

In an embodiment, the first, second, and third light-emitting areas LA1, LA2, and LA3 may be disposed to be spaced apart from each other and repeat in a direction each other in the plan view. The light-blocking area BA may surround the first, second, and third light-emitting areas LA1, LA2, and LA3 in the plan view. For example, the light-blocking area BA may have a grid shape in the plan view.

The display device DD may include the base substrate BSUB, insulating layers such as first, second, third, and fourth insulating layers IL1, IL2, IL3, and IL4, driving elements such as first, second, and third driving elements TR1, TR2, and TR3, light-emitting elements such as first, second, and third light-emitting elements LED1, LED2, and LED3, a pixel defining layer PDL, a capping layer CPL, a dam structure DAM, a filling layer FM, the sealing member SM, and the encapsulation substrate ESUB. The description may be equally applied to the base substrate BSUB, the sealing member SM, and the encapsulation substrate ESUB.

As described above, the base substrate BSUB and the encapsulation substrate ESUB may face each other in the first direction DR1. The first, second, third, and fourth insulating layers IL1, IL2, IL3, and IL4, the first, second, and third driving elements TR1, TR2, and TR3, the first, second, and third light-emitting elements LED1, LED2, and LED3, the pixel defining layer PDL, the capping layer CPL, the dam structure DAM, and the filling layer FM may be disposed between the base substrate BSUB and the encapsulation substrate ESUB.

Here, the first driving element TR1 may include a first active pattern ACT1, a first gate electrode GE1, and a first signal electrode DE1, the second driving element TR2 may include a second active pattern ACT2, a second gate electrode GE2, and a second signal electrode DE2, and the third driving element TR3 may include a third active pattern ACT3, a third gate electrode GE3, and a third signal electrode DE3. The first, second, and third driving elements TR1, TR2, and TR3 may be disposed in the display area DA on the base substrate BSUB.

In addition, the first light-emitting element LED1 may include a first pixel electrode PE1, a first light-emitting layer EL1, and a common electrode CE, the second light-emitting element LED2 may include a second pixel electrode PE2, a second light-emitting layer EL2, and a common electrode CE, the third light-emitting element LED3 may include a third pixel electrode PE3, a third light-emitting layer EL3, and a common electrode CE. The first, second, and third light-emitting elements LED1, LED2, and LED3 may be disposed in the display area DA on the base substrate BSUB.

Meanwhile, the first, second, third, and fourth insulating layers IL1, IL2, IL3, and IL4, the first, second, and third driving elements TR1, TR2, and TR3, the first, second, and third light-emitting elements LED 1, LED2, and LED3, the pixel defining layer PDL, and the capping layer CPL may be components included in the display element layer DEL of FIG. 2.

The first insulating layer IL1 may be disposed on the base substrate BSUB. The first insulating layer IL1 may prevent metal atoms or impurities from diffusing from the base substrate BSUB to the first, second, and third driving elements TR1, TR2, and TR3. The first insulating layer IL1 may be disposed in the display area DA and the peripheral area PA, on the base substrate BSUB. The first insulating layer IL1 may include an inorganic insulating material. Examples of the inorganic insulating material which can be used as the first insulating layer IL1 may include silicon oxide, silicon nitride, silicon oxynitride, and the like. These can be used alone or in combination with each other.

An active pattern layer including the first, second, and third active patterns ACT1, ACT2, and ACT3 may be disposed on the first insulating layer IL1. In an embodiment, each of the first, second, and third active patterns ACT1, ACT2, and ACT3 may include a silicon semiconductor material or an oxide semiconductor material. Examples of the silicon semiconductor material which can be used as the first, second, and third active patterns ACT1, ACT2, and ACT3 may include amorphous silicon, polycrystalline silicon, or the like. Examples of the oxide semiconductor material which can be used as the first, second, and third active patterns ACT1, ACT2, and ACT3 may include zinc oxide (ZnOₓ), gallium oxide (GaOₓ), tin oxide (SnOₓ), indium oxide (InOₓ), indium gallium oxide (IGO), indium zinc oxide (IZO), indium tin oxide (ITO), indium zinc tin oxide (IZTO), indium gallium zinc oxide (IGZO), and the like. These can be used alone or in combination with each other.

The second insulating layer IL2 may be disposed on the first insulating layer IL1. The second insulating layer IL2 may cover the first, second, and third active patterns ACT1, ACT2, and ACT3. Alternatively, the second insulating layer IL2 may be disposed in a pattern shape to expose a portion of each of the first, second, and third active patterns ACT1, ACT2, and ACT3 to outside the second insulating layer IL2. The second insulating layer IL2 may include an inorganic insulating material. Examples of the inorganic insulating material which can be used as the second insulating layer IL2 may include silicon oxide, silicon nitride, silicon oxynitride, and the like. These can be used alone or in combination with each other.

A first electrode layer including the first, second, and third gate electrodes GE1, GE2, and GE3 may be disposed on the second insulating layer IL2. In an embodiment, each of the first, second, and third gate electrodes GE1, GE2, and GE3 may include metal, alloy, conductive metal oxide, transparent conductive material, and the like. These can be used alone or in combination with each other.

The third insulating layer IL3 may be disposed on the second insulating layer IL2. In an embodiment, the third insulating layer IL3 may cover the first, second, and third gate electrodes GE1, GE2, and GE3. The third insulating layer IL3 may be disposed in the display area DA and the peripheral area PA, on the base substrate BSUB. The third insulating layer IL3 may include an inorganic insulating material. Examples of inorganic insulating materials which can be used as the third insulating layer IL3 may include silicon oxide, silicon nitride, silicon oxynitride, and the like. These can be used alone or in combination with each other.

A second electrode layer including the first, second, and third signal electrodes DE1, DE2, and DE3 may be disposed on the third insulating layer IL3. The first, second, and third signal electrodes DE1, DE2, DE3 may be connected to the first, second, and third active patterns ACT1, ACT2, and ACT3 through contact holes penetrating the second and third insulating layers IL2 and IL3, respectively. For example, the first signal electrode DE1 may be connected to the first active pattern ACT1, the second signal electrode DE2 may be connected to the second active pattern ACT2, and the third signal electrode DE3 may be connected to the third active pattern ACT3. Each of the first, second, and third signal electrodes DE1, DE2, and DE3 may include metal, alloy, conductive metal oxide, transparent conductive material, and the like. These can be used alone or in combination with each other.

The fourth insulating layer IL4 may be disposed on the third insulating layer IL3. The fourth insulating layer IL4 may cover the first, second, and third signal electrodes DE1, DE2, and DE3. The fourth insulating layer IL4 may be disposed in the display area DA and the peripheral area PA, on the base substrate BSUB. The fourth insulating layer IL4 may include an organic insulating material. Examples of organic insulating materials which can be used as the fourth insulating layer IL4 may include photoresist, polyacryl-based resin, polyimide-based resin, polyamide-based resin, siloxane-based resin, acryl-based resin, epoxy-based resin, and the like. These can be used alone or in combination with each other. The fourth insulating layer IL4 may have a single-layer structure or a multi-layer structure including a plurality of insulating layers.

A pixel electrode layer including the first, second, and third pixel electrodes PE1, PE2, and PE3 may be disposed on the fourth insulating layer IL4. Each of the first, second, and third pixel electrodes PE1, PE2, and PE3 may include metal, alloy, conductive metal oxide, transparent conductive material, and the like. These can be used alone or in combination with each other.

The first, second, and third pixel electrodes PE1, PE2, and PE3 may be connected to the first, second, and third driving elements TR1, TR2, and TR3 through contact holes formed in the fourth insulating layer IL4, respectively.

The pixel defining layer PDL may be disposed on the fourth insulating layer IL4 and the first, second, and third pixel electrodes PE1, PE2, and PE3. The pixel defining layer PDL may be disposed in the display area DA and the peripheral area PA, on the base substrate BSUB. The pixel defining layer PDL may include an organic insulating material. Examples of the organic insulating material may include photoresist, polyacryl-based resin, polyimide-based resin, polyamide-based resin, siloxane-based resin, acryl-based resin, epoxy-based resin, and the like. These can be used alone or in combination with each other. The pixel defining layer PDL may define a pixel opening therein which exposes a portion of each of the first, second, and third pixel electrodes PE1, PE2, and PE3 to outside the pixel defining layer PDL. The light-emitting area may be defined by the pixel opening.

The first light-emitting layer EL1 may be disposed on the first pixel electrode PE1 exposed by the pixel opening. That is, the first light-emitting layer EL1 may be disposed in the first light-emitting area LA1. The first light-emitting layer EL1 may emit light of a first color. That is, the first light-emitting layer EL1 may include a first light-emitting material which emits light of the first color. For example, the first color may be red. However, the present disclosure is not necessarily limited thereto. The first light-emitting material may include an organic light-emitting material and/or an inorganic light-emitting material such as quantum dots.

The second light-emitting layer EL2 may be disposed on the second pixel electrode PE2 exposed by the pixel opening. That is, the second light-emitting layer EL2 may be disposed in the second light-emitting area LA2. The second light-emitting layer EL2 may emit light of a second color different from the first color. That is, the second light-emitting layer EL2 may include a second light-emitting material which emits light of the second color. For example, the second color may be green. However, the present disclosure is not necessarily limited thereto. The second light-emitting material may include an organic light-emitting material and/or an inorganic light-emitting material such as quantum dots.

The third light-emitting layer EL3 may be disposed on the third pixel electrode PE3 exposed by the pixel opening. That is, the third light-emitting layer EL3 may be disposed in the third light-emitting area LA3. The third light-emitting layer EL3 may emit light of a third color different from the first color and the second color. That is, the third light-emitting layer EL3 may include a third light-emitting material which emits light of the third color. For example, the third color may be blue. However, the present invention is not necessarily limited thereto. The third light-emitting material may include an organic light-emitting material and/or an inorganic light-emitting material such as quantum dots.

In an embodiment, functional layers (not shown) such as a hole injection layer, a hole transport layer, an electron transport layer, an electron injection layer, and the like may be disposed on and/or under each of the first, second, and third light-emitting layers EL1, EL2, and EL3.

The common electrode CE may be disposed on the first, second, and third light-emitting layers EL1, EL2, and EL3. The common electrode CE may include a conductive material such as a metal, alloy, conductive metal nitride, conductive metal oxide, transparent conductive material, and the like. These can be used alone or in combination with each other. The common electrode CE may have a single-layer structure or a multi-layer structure including a plurality of conductive layers. In an embodiment, the common electrode CE may extend continuously across the light-emitting area.

As a result, the first light-emitting element LED1 including the first pixel electrode PE1, the first light-emitting layer EL1, and the common electrode CE may emit light of the first color. In addition, the second light-emitting element LED2 including the second pixel electrode PE2, the second light-emitting layer EL2, and the common electrode CE may emit light of the second color. In addition, the third light-emitting element LED3 including the third pixel electrode PE3, the third light-emitting layer EL3, and the common electrode CE may emit light of the third color.

The capping layer CPL may be disposed on the common electrode CE. The capping layer CPL may protect the common electrode CE. For example, the capping layer CPL may include an organic insulating material and/or an inorganic insulating material.

The filling layer FM may be disposed between the base substrate BSUB and the encapsulation substrate ESUB. Specifically, the filling layer FM may be disposed on the display element layer DEL. For example, an entirety of the filling layer FM may be disposed in the display area DA, on the base substrate BSUB, or a portion may additionally be disposed in a portion of the peripheral area PA. The filling layer FM may act as a buffer against external pressure applied to the display device DD (e.g., an impact absorbing member). In an embodiment, the filling layer FM may include a transparent material. For example, the filling layer FM may include silicone-based resin, acrylic-based resin, epoxy-based resin, and the like. These can be used alone or in combination with each other. However, the present disclosure is not necessarily limited thereto.

The dam structure DAM may be disposed in the peripheral area PA on the base substrate BSUB. For example, the dam structure DAM may be disposed to surround the display area DA, and the sealing member SM may be disposed to surround the dam structure DAM, in the plan view. In an embodiment, the dam structure DAM may be directly disposed on an upper surface of the pixel defining layer PDL. However, the present disclosure is not necessarily limited thereto.

In an embodiment, a dam represented by the dam structure DAM may include a first sub-dam SDM1 as a first sub-dam layer, a second sub-dam SDM2 as a second sub-dam layer, and a third sub-dam SDM3 as a third sub-dam layer. For example, the dam structure DAM may have a multi-layer structure in which the first sub-dam SDM1, the second sub-dam SDM2, and the third sub-dam SDM3 are sequentially stacked in the first direction DR1. The various sub-dams may be considered in a same layer as other pattern layers of the display element layer DEL. As being in a same layer, elements may be formed in a same process and/or include a same material as each other, elements may be respective portions of a same material layer, elements may be on a same layer by forming an interface with a same underlying or overlying layer, elements may be coplanar with each other or be disposed in a same thickness, etc., without being limited thereto.

The first sub-dam SDM1 may include the same material (e.g., a first light-emitting material) as the first light-emitting layer EL1. For example, the first sub-dam SDM1 may be formed together with the first light-emitting layer EL1 in the same process, such that the first sub-dam SDM1 and the first light-emitting layer EL1 are respective patterns of a same material layer. Accordingly, the first sub-dam SDM1 may include the first light-emitting material which emits light of the first color.

In an embodiment, a thickness of the first sub-dam SDM1 in the first direction DR1 may be substantially the same as a thickness of the first light-emitting layer EL1 in the first direction DR1. For example, the first sub-dam SDM1 and the first light-emitting layer EL1 may have the same or similar thickness.

The second sub-dam SDM2 may be disposed on the first sub-dam SDM1. For example, the second sub-dam SDM2 may be directly disposed on the first sub-dam SDM1. That is, the first sub-dam SDM1 and the second sub-dam SDM2 may overlap in the plan view.

The second sub-dam SDM2 may include the same material (e.g., a second light-emitting material) as the second light-emitting layer EL2. For example, the second sub-dam SDM2 may be formed together with the second light-emitting layer EL2 in the same process, such that the second sub-dam SDM2 and the second light-emitting layer EL2 are respective patterns of a same material layer. Accordingly, the second sub-dam SDM2 may include the second light-emitting material which emits light of the second color.

In an embodiment, the thickness of the second sub-dam SDM2 in the first direction DR1 may be substantially the same as the thickness of the second light-emitting layer EL2 in the first direction DR1. For example, the second sub-dam SDM2 and the second light-emitting layer EL2 may have the same or similar thickness.

The third sub-dam SDM3 may be disposed on the second sub-dam SDM2. For example, the third sub-dam SDM3 may be directly disposed on the second sub-dam SDM2. That is, the first sub-dam SDM1, the second sub-dam SDM2, and the third sub-dam SDM3 may overlap each other in the plan view.

The third sub-dam SDM3 may include the same material (e.g., a third light-emitting material) as the third light-emitting layer EL3. For example, the third sub-dam SDM3 may be formed together with the third light-emitting layer EL3 in the same process, such that the third sub-dam SDM3 and the third light-emitting layer EL3 are respective patterns of a same material layer. Accordingly, the third sub-dam SDM3 may include the third light-emitting material which emits light of the third color.

Meanwhile, although in FIG. 3, the dam structure DAM is shown as having a three-layer structure in which the first sub-dam SDM1, the second sub-dam SDM2, and the third sub-dam SDM3 are sequentially stacked, the present disclosure is not necessarily limited to thereto. For example, in embodiments, the dam structure DAM may have a multi-layer structure in which four or more sub-dams are sequentially stacked.

In the process of forming the filling layer FM in a method of providing the display device DD, the filling material may shrink such as by curing. When the filling material shrinks by curing, bubbles may be generated, and the bubbles may move to the display element layer DEL, causing lifting phenomenon (i.e., voids) of the capping layer CPL and/or common electrode CE. If the voids are visible from the outside, the display quality of the display device DD may deteriorate.

According to embodiments of the present disclosure, the dam structure DAM with a sufficient thickness may be disposed in the peripheral area PA on the base substrate BSUB. For example, the sub-dams included in the dam structure DAM may have a thickness substantially the same as the thickness of a light-emitting layer, and accordingly, the dam structure DAM may have a sufficient thickness in the first direction DR1. Accordingly, the inner space in which the filling layer FM is disposed among a total inner space between the base substrate BSUB and the encapsulation substrate ESUB may be reduced by the dam structure DAM. That is, the amount of the filling material for forming the filling layer FM may be reduced.

For example, the dam structure DAM may prevent or reduce the filling material from overflowing to the outside (e.g., in the second direction DR2 of FIG. 3) of the dam structure DAM during the formation of the filling layer FM. For example, the dam structure DAM may surround the filling layer FM in the plan view. Accordingly, the amount of the filling material for forming the filling layer FM may be reduced since a volume of the inner space within the peripheral area PA excludes the filling layer FM. The volume of the inner space which is unoccupied by the filling layer FM may be an empty space or gap between the facing substrates, without being limited thereto. Accordingly, the generation of bubbles due to shrinkage of the filling material may be reduced or prevented. Accordingly, the display quality of the display device DD may be improved.

In addition, the dam structure DAM according to embodiments of the present disclosure may have a multi-layer structure in which sub-dams including light-emitting materials which emit light of different colors are stacked. Accordingly, the dam structure DAM may perform a light-blocking function (e.g., a light-blocking member). That is, the dam structure DAM may reduce or prevent circuit structures such as lines, driving circuits, and the like disposed in the peripheral area PA on the base substrate BSUB from being visible from the outside. In an embodiment, the light-blocking dam may overlap the structures such as lines, driving circuits, and the like disposed in the peripheral area PA, such that these structures are not visible from outside the display device DD. Accordingly, the display quality of the display device DD may be improved.

In addition, as the display device DD includes the dam structure DAM, a separate light-blocking member may be not disposed on one side of the encapsulation substrate ESUB to prevent the lines and/or the circuit structure from being visible. That is, a separate process for forming the light-blocking member may not be required. Accordingly, the structure of the display device DD may be simplified and the manufacturing process may be facilitated.

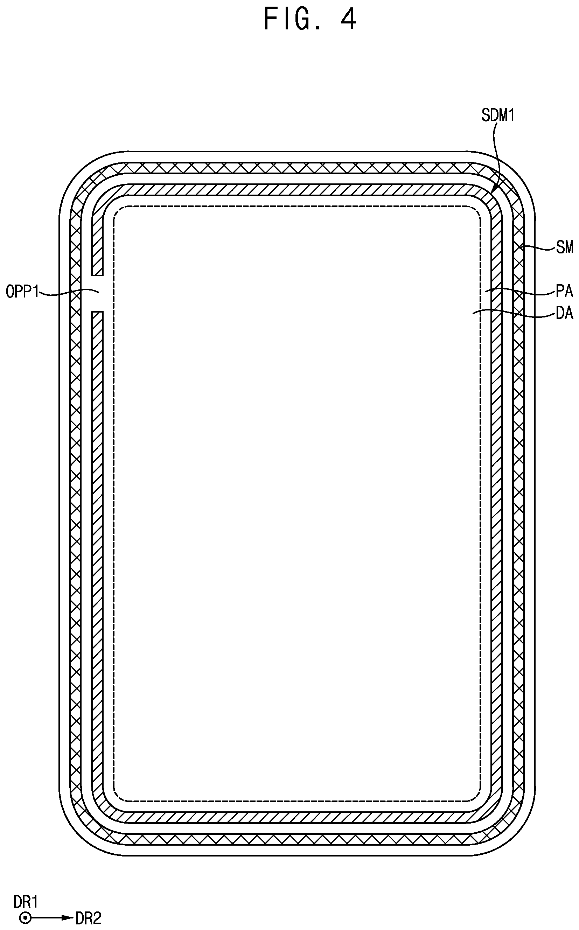

FIGS. 4, 5, 6, 7, 8, 9, and 10 are views for explaining a dam structure DAM of FIG. 3.

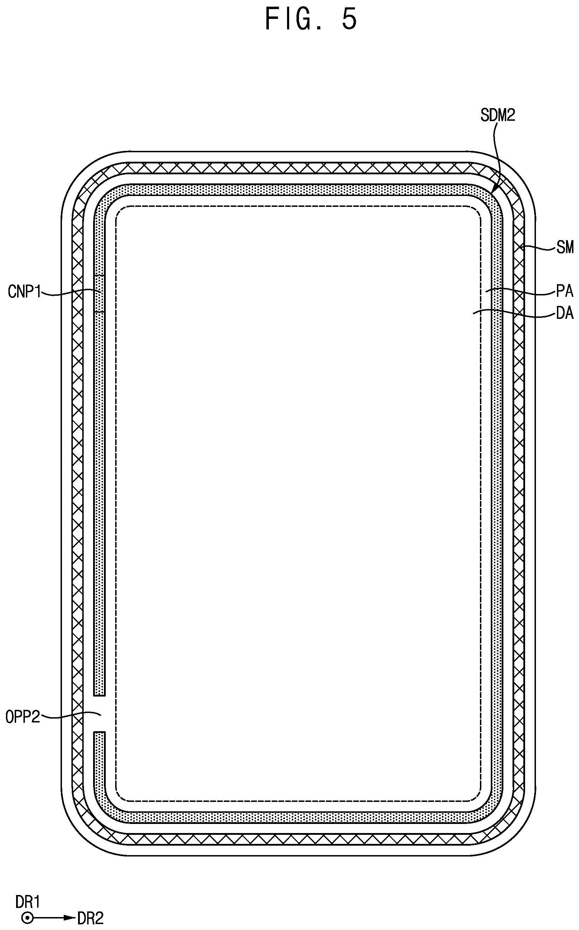

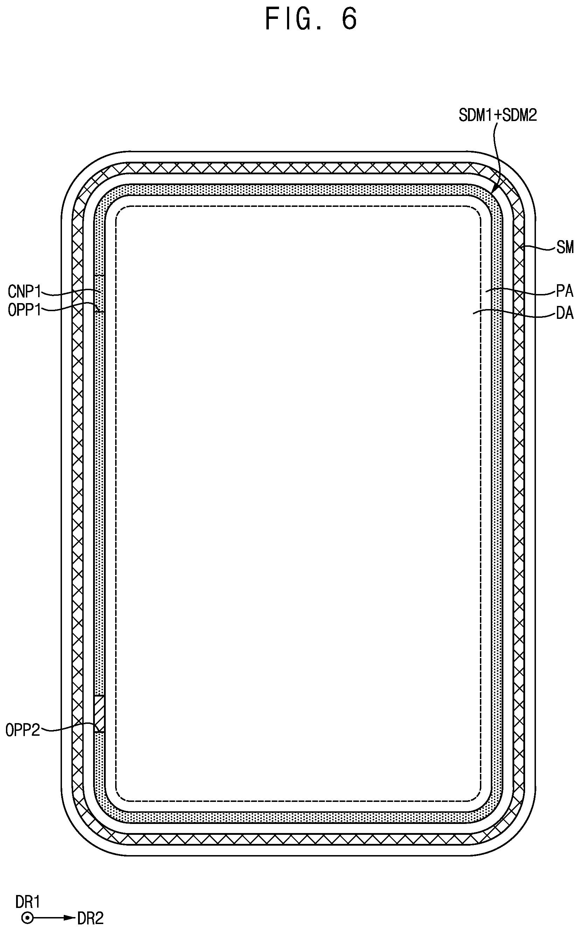

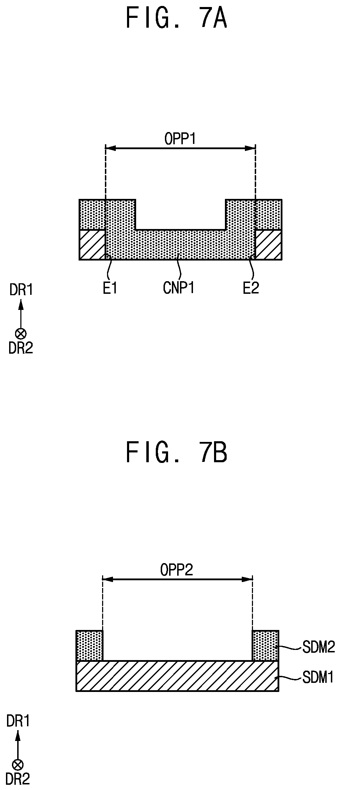

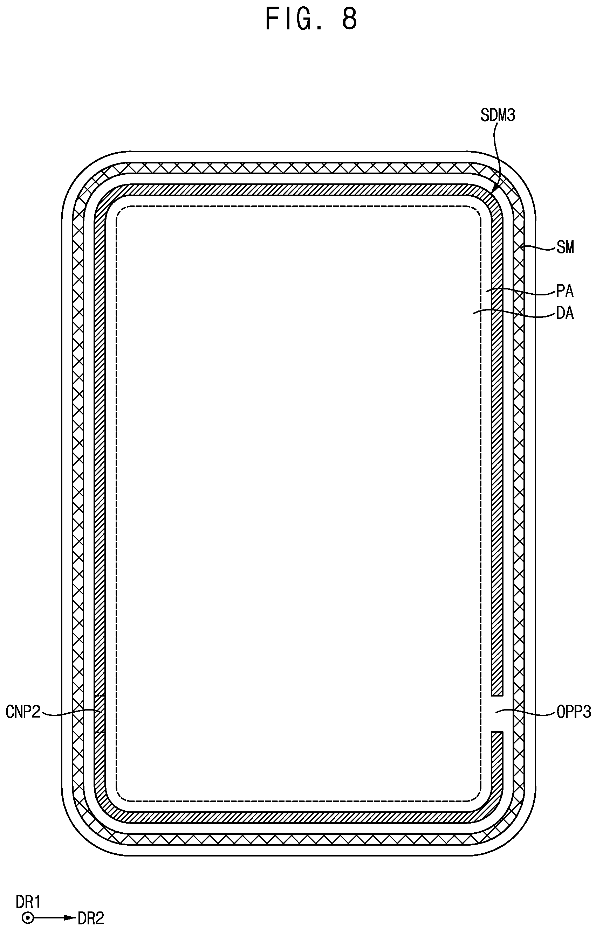

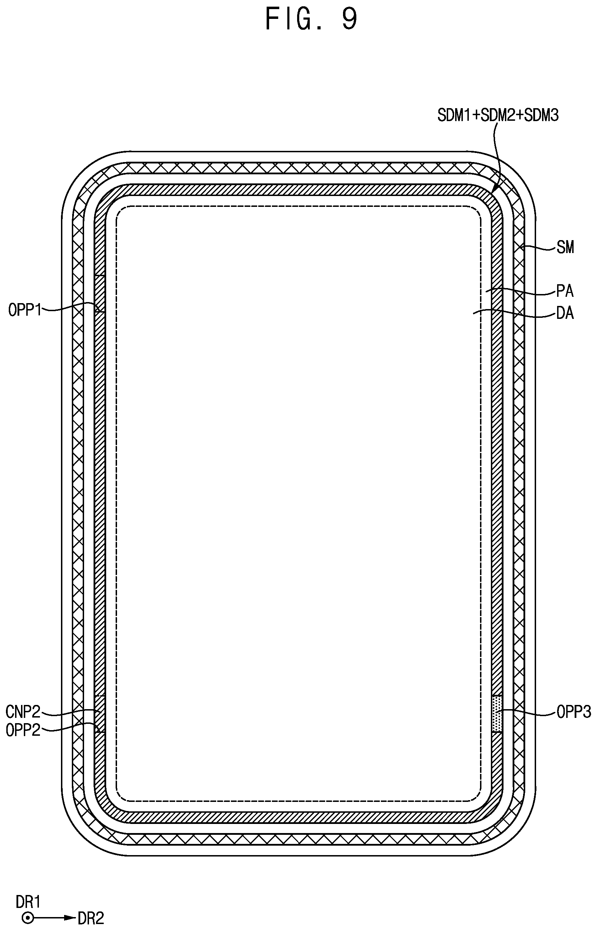

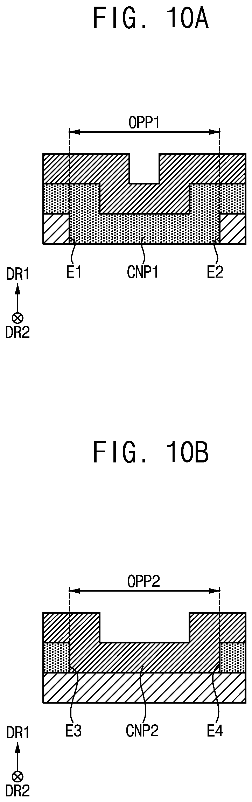

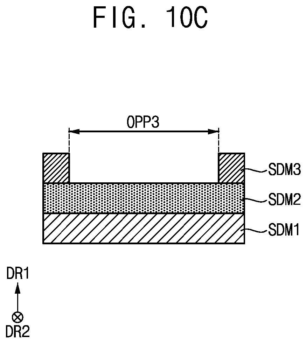

Specifically, FIG. 4 is a plan view showing the first sub-dam SDM1, FIG. 5 is a plan view showing the second sub-dam SDM2, FIG. 6 is a plan view showing the first sub-dam SDM1 and the second sub-dam SDM2 together, FIGS. 7A and 7B are cross-sectional views respectively showing a first open portion OPP1 and a second open portion OPP2 of FIG. 6, FIG. 8 is a plan view showing the third sub-dam SDM3, FIG. 9 is a plan view showing the first sub-dam SDM1, the second sub-dam SDM2 and the third sub-dam SDM3 together, and FIGS. 10A, 10B and 10C are cross-sectional views respectively showing the first, second, and third open portions OPP1, OPP2, and OPP3 of FIG. 9. Hereinafter, the dam structure DAM will be described in more detail with further reference to FIGS. 4, 5, 6, 7, 8, 9, and 10.

Referring further to FIG. 4, the first sub-dam SDM1 may have an open ring shape in which at least a portion of the first sub-dam SDM1 is cut off to define the first open portion OPP1. For example, the first sub-dam SDM1 may be formed through a process of selectively providing the first light-emitting material to a specific area using a mask in a method of providing the display device DD. Accordingly, a support for supporting the mask may be located in a first support area. Accordingly, the first light-emitting material may not be provided to the first support area by the support occupying the first support area. That is, the first sub-dam SDM1 may not be formed in the first support area. Accordingly, the first sub-dam SDM1 may be disconnected at the first support area to have an open ring shape defining the first open portion OPP1 (e.g., a first disconnection) corresponding to the first support area.

The first open portion OPP1 may expose a portion of a layer immediately under the first sub-dam SDM1 to outside the first sub-dam SDM1. For example, the first open portion OPP1 may expose a portion of the pixel defining layer PDL to outside the first sub-dam SDM1. However, the present disclosure is not necessarily limited thereto.

Referring further to FIGS. 5, 6, and 7, the second sub-dam SDM2 may have an open ring shape in which at least a portion of the second sub-dam SDM2 is cut off to define the second open portion OPP2. For example, the second sub-dam SDM2 may be formed through a process of selectively providing the second light-emitting material to a specific area using a mask in a method of providing the display device DD. Accordingly, a support for supporting the mask may be located in a second support area. Accordingly, the second light-emitting material may not be provided to the second support area by the support occupying the second support area. That is, the second sub-dam SDM2 may not be formed in the second support area. Accordingly, the second sub-dam SDM2 may be disconnected at the second support area to have an open ring shape defining the second open portion OPP2 (e.g., a second disconnection) corresponding to the second support area.

The first support area and the second support area may be different from each other. That is, the first open portion OPP1 of the first sub-dam SDM1 and the second open portion OPP2 of the second sub-dam SDM2 may correspond to different areas. For example, the first open portion OPP1 and the second open portion OPP2 may be spaced apart from each other in the plan view.

Referring to FIGS. 4 and 5, for example, each of the sealing member SM and the dam structures DAM has a major dimension (e.g., a length) extending along the plane defined by the second direction DR2 and the third direction, to define an extension direction. The extension direction may be parallel to an outer edge of the display device DD, an outer edge of the display area DA, an inner edge of the peripheral area PA, a boundary between the display area DA and the peripheral area PA, etc., without being limited thereto. Disconnections of sublayers within the dam structure DAM may be in different locations along the extension direction of the dam structure DAM. A disconnection in a respective sub-dam layer may be defined by side surfaces of the respective sub-dam layer which face each other across the open portion.

Accordingly, as shown in FIGS. 6 and 7, the second open portion OPP2 may expose a portion of the first sub-dam SDM1 to outside the second sub-dam SDM2. That is, the second open portion OPP2 may expose a portion of the first sub-dam SDM1 disposed in the second support area. In addition, a portion of the second sub-dam SDM2 may be disposed in the first open portion OPP1. For example, a material of the second sub-dam SDM2 which extends along an upper surface of the first sub-dam SDM1 may extend from the upper surface and into the first open portion OPP1 to define a first connection portion CNP1 (e.g., a connection portion) disposed in the first open portion OPP1. The first connection portion CNP1 may connect or contact both a first side E1 (e.g., a first side surface) and a second side E2 (e.g., a second side surface) of the first sub-dam SDM1 defining the first open portion OPP1. That is, the first connection portion CNP1 may fill a space between the first side E1 and the second side E2 of the first sub-dam SDM1 and connect remaining portions of the second sub-dam SDM2 to each other by extending across the first open portion OPP1.

Referring further to FIGS. 8, 9, and 10, the third sub-dam SDM3 may have an open ring shape in which at least a portion of the third sub-dam SDM3 is cut off to define the third open portion OPP3. For example, the third sub-dam SDM3 may be formed through a process of selectively providing the third light-emitting material to a specific area using a mask in a method of providing the display device DD. Accordingly, a support for supporting the mask may be located in a third support area. Accordingly, the third light-emitting material may not be provided to the third support area by the support occupying the third support area. That is, the third sub-dam SDM3 may not be formed in the third support area. Accordingly, the third sub-dam SDM3 may be disconnected at the third support area (e.g., a third disconnection) to have an open ring shape defining the third open portion OPP3 corresponding to the third support area.

The first support area, the second support area, and the third support area may be different from each other. That is, the first open portion OPP1 of the first sub-dam SDM1, the second open portion OPP2 of the second sub-dam SDM2, and the third open portion OPP3 of the third sub-dam SDM3 may correspond to different areas or positions along the dam structure DAM. For example, the first open portion OPP1, the second open portion OPP2, and the third open portion OPP3 may be spaced apart from each other along an extension of the dam structure DAM, in the plan view.

Accordingly, as shown in FIGS. 9 and 10, the third open portion OPP3 may expose a portion of the second sub-dam SDM2 to outside the third sub-dam SDM3. That is, the third open portion OPP3 may expose a portion of the second sub-dam SDM2 disposed in the third support area. That is, in the third support area corresponding to the third open portion OPP3, the third sub-dam SDM3 may not be disposed on the second sub-dam SDM2, and the first sub-dam SDM1 and the second sub-dam SDM2 may be selectively stacked along the first direction DR1.

In addition, a portion of the third sub-dam SDM3 may be disposed in the second open portion OPP2. For example, a material of the third sub-dam SDM3 which extends along an upper surface of the second sub-dam SDM2 may extend from the upper surface and into the second open portion OPP2 to define the second connection portion CNP2 disposed in the second open portion OPP2. The second connection portion CNP2 may connect a third side E3 (e.g., a first side surface) and a fourth side E4 (e.g., a second side surface) of the second sub-dam SDM2 defining the second open portion OPP2. That is, the second connection portion CNP2 may fill the space between the third side E3 and the fourth side E4 of the second sub-dam SDM2 and connect remaining portions of the third sub-dam SDM3 to each other by extending across the second open portion OPP2.

As a result, the second connection portion CNP2 may be directly disposed on the first sub-dam SDM1 as a layer immediately under the second sub-dam SDM2 which is exposed by the second open portion OPP2. That is, in the second support area corresponding to the second open portion OPP2, the second sub-dam SDM2 may not be disposed between the first sub-dam SDM1 and the third sub-dam SDM3, Accordingly, the first sub-dam SDM1 and the third sub-dam SDM3 may be sequentially stacked.

In addition, another portion of the third sub-dam SDM3 may be directly disposed on the first connection portion CNP1 of the second sub-dam SDM2. That is, in the first support area corresponding to the first open portion OPP1, the first sub-dam SDM1 may not be disposed under the second sub-dam SDM2, and the second sub-dam SDM2 and the third sub-dam SDM3 may be selectively stacked along the first direction DR1.

According to embodiments of the present disclosure, each of the sub-dams included in the dam structure DAM may have an open ring shape in which at least a portion is cut off to define an open portion, and the open portions of the sub-dams may be spaced apart from each other in the plan view. Accordingly, the dam structure DAM may not be cut off or disconnected. That is, even if the sub-dams (e.g., the first, second, and third sub-dams SDM1, SDM2, and SDM3) included in the dam structure DAM have an open ring shape, the dam structure DAM may have an overall closed ring shape. For example, the dam structure DAM may extend continuously to entirely surround the display area DA in the plan view. Accordingly, the dam structure DAM may prevent or reduce the filling material of the filling layer FM from overflowing to the outside of the dam structure DAM.

In addition, as the open portions of the sub-dams are spaced apart from each other in the plan view, at least two or more sub-dams may be sequentially stacked in areas corresponding to the open portions. Accordingly, even in areas corresponding to the open portions of the sub-dams, the dam structure DAM may reduce or prevent the lines and/or the circuit structure from being visible from the outside.

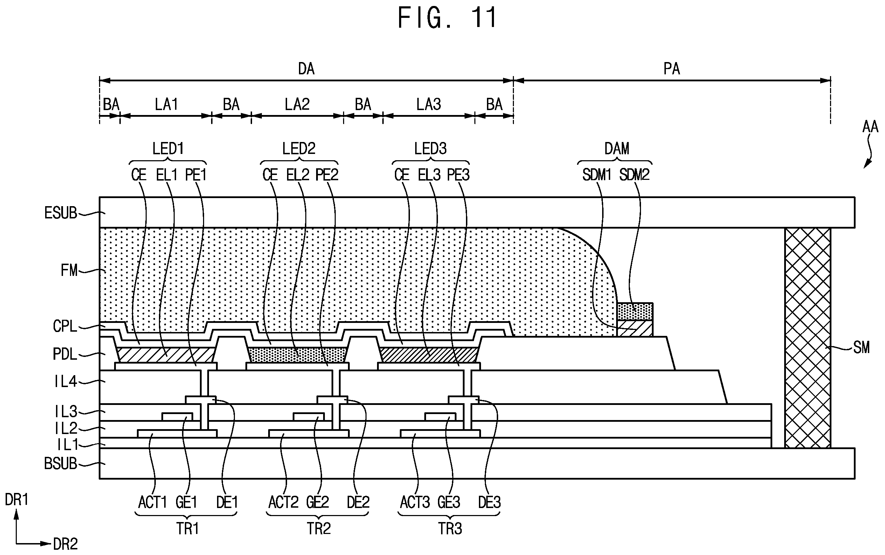

FIGS. 11, 12, 13, 14, and 15 are views showing various enlarged cross-sectional examples of the area AA of FIG. 2.

That is, each of FIGS. 11, 12, 13, 14, and 15 may correspond to an enlarged view of FIG. 3. Hereinafter, display devices according to various embodiments of the present disclosure will be described with reference to FIGS. 11, 12, 13, 14, and 15. In the following description, the description will focus on differences from the display device DD described with reference to FIG. 3, and overlapping descriptions will be omitted or simplified.

Referring to FIG. 11, in an embodiment, one of the first sub-dam SDM1, the second sub-dam SDM2, and the third sub-dam SDM3 may be omitted. That is, the dam structure DAM may have a two-layer structure in which two sub-dams among the first sub-dam SDM1, the second sub-dam SDM2, and the third sub-dam SDM3 are sequentially stacked. In this case, manufacturing cost and manufacturing time may be reduced in a method of providing the display device DD, while improving the display quality of the display device DD.

For example, as shown in FIG. 11, the dam structure DAM may have a two-layer structure in which the first sub-dam SDM1 and the second sub-dam SDM2 are sequentially stacked. However, the present disclosure is not necessarily limited to this, and the sub-dams included in the dam structure DAM of the two-layer structure may be variously selected from the first sub-dam SDM1, the second sub-dam SDM2, and the third sub-dam SDM3. In addition, the stacking order of the sub-dams may also be changed in various ways.

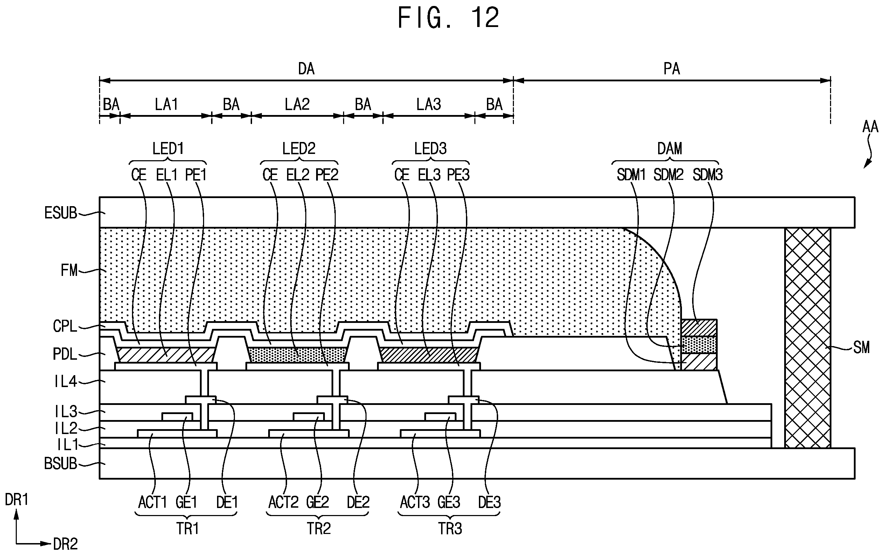

Referring to FIG. 12, in an embodiment, the dam structure DAM may be directly disposed on the upper surface of the fourth insulating layer IL4. That is, the dam structure DAM may be located at the same level as (e.g., coplanar with or in a same layer as) the first, second, and third pixel electrodes PE1, PE2, and PE3 and the base substrate BSUB. In this case, the first open portion (OPP1, see FIG. 4) of the first sub-dam SDM1) may expose a portion of the fourth insulating layer IL4 to outside the first sub-dam SDM1. In this case, while improving the display quality of the display device DD, it may be easier to secure a buffering effect by the filling layer FM.

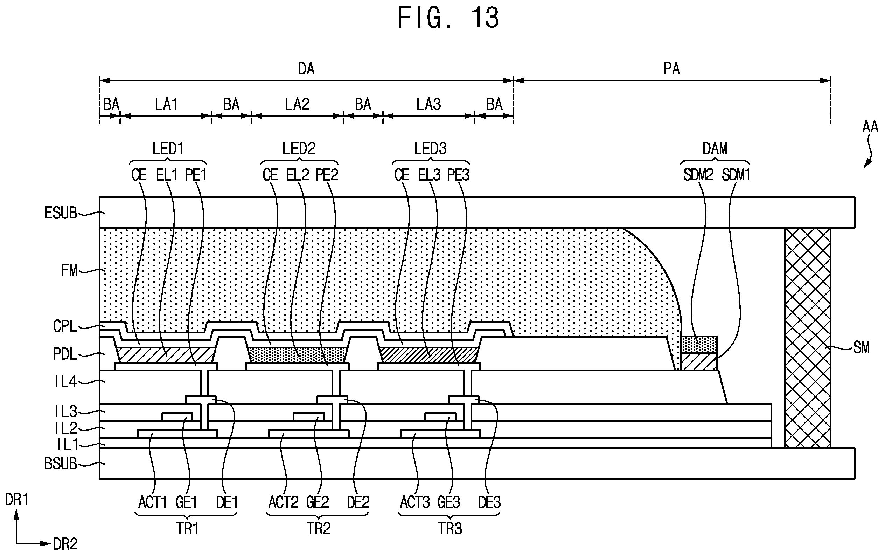

Referring to FIG. 13, even in the embodiment in which the dam structure DAM is directly disposed on the fourth insulating layer IL4, any one of the first sub-dam SDM1, the second sub-dam SDM2, and the third sub-dam SDM3 may be omitted. Accordingly, the manufacturing cost and manufacturing time of the display device DD may be reduced in a method of providing the display device DD.

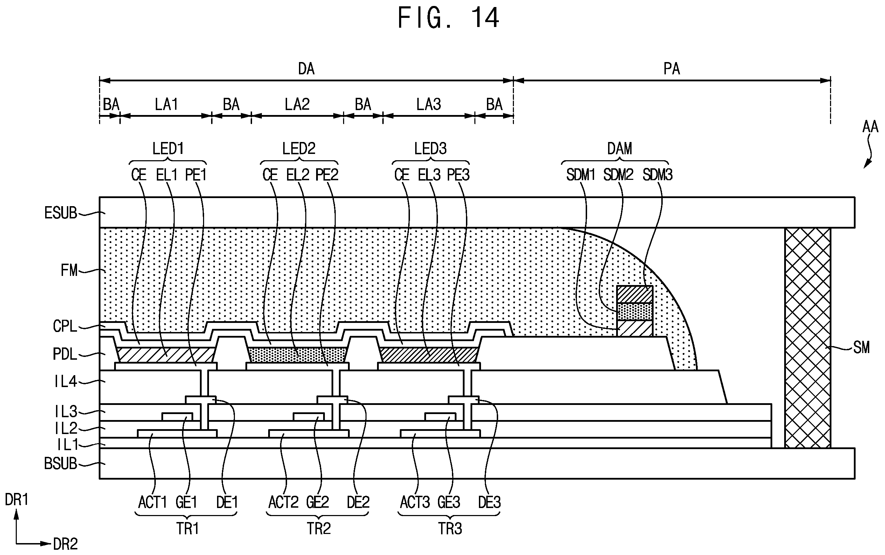

Referring to FIG. 14, in an embodiment, the filling layer FM may cover the dam structure DAM. For example, at least a portion of the filling layer FM may overflow to the outside of the dam structure DAM, by extending along the top surface and the end surface of the dam structure DAM. That is, in some cases, the filling layer FM may not be completely blocked by the dam structure DAM. Even in this case, the space the volume of the inner space which is occupied by the filling layer FM between the base substrate BSUB and the encapsulation substrate ESUB may be reduced by the dam structure DAM of sufficient thickness, and the amount of the filler material for forming the filling layer FM may be reduced. Accordingly, the generation of air bubbles caused by shrinkage of the filling material may be reduced or prevented. Accordingly, the display quality of the display device DD may be improved.

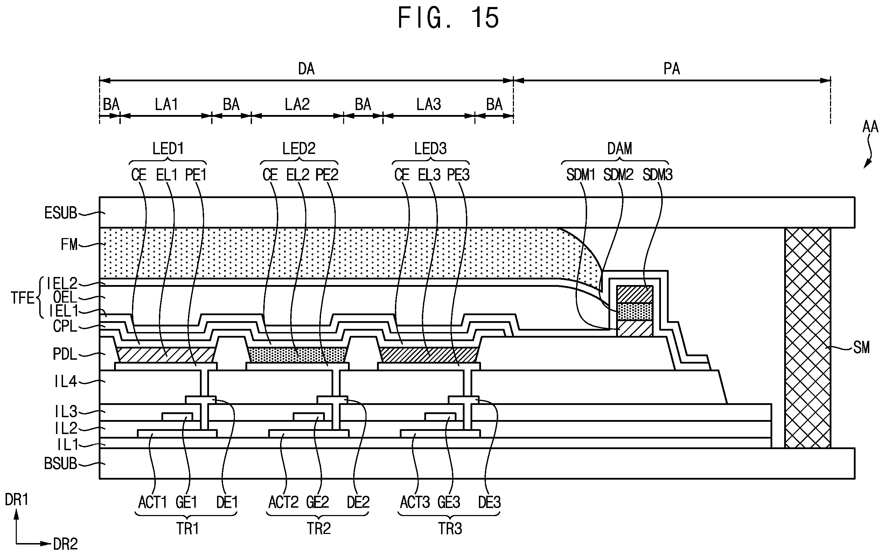

Referring to FIG. 15, in an embodiment, the display device DD (see FIGS. 1 and 2) may further include a thin film encapsulation layer TFE as an encapsulation layer. The thin film encapsulation layer TFE may be disposed on the capping layer CPL. In an embodiment, the thin film encapsulation layer TFE may include a first inorganic encapsulation layer IEL1 on the capping layer CPL, an organic encapsulation layer OEL on the first inorganic encapsulation layer IEL1, and a second inorganic encapsulation layer IEL2 on the organic encapsulation layer OEL.

An inorganic encapsulation layer of the encapsulation layer may extend from the display area DA and into the peripheral area PA. The inorganic encapsulation layer may extend over the dam structure DAM to cover the dam structure DAM. In an embodiment, the dam structure DAM may be covered by the first inorganic encapsulation layer IEL1 and the second inorganic encapsulation layer IEL2 which contact each other in the peripheral area PA.

In an embodiment, the dam structure DAM may also serve to prevent an organic material from overflowing to the outside (e.g., in the second direction DR2 of FIG. 15) of the dam structure DAM during the formation of the organic encapsulation layer OEL.

The thin film encapsulation layer TFE may prevent impurities such as moisture from penetrating into the first, second, and third light-emitting elements LED1, LED2, and LED3. That is, the display element layer DEL may be double sealed by the thin film encapsulation layer TFE along with the encapsulation substrate ESUB. Accordingly, the durability of the display device DD may be further improved. In an embodiment, the display element layer DEL may be sealed by only one layer among the thin film encapsulation layer TFE and the encapsulation substrate ESUB.

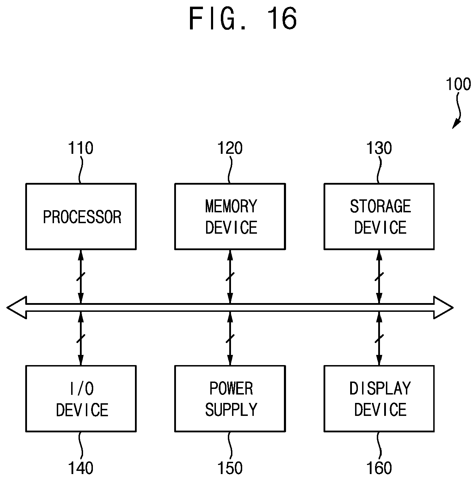

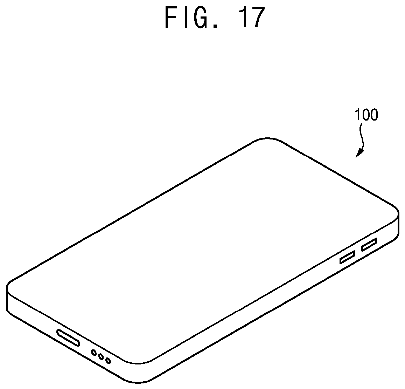

FIG. 16 is a block diagram showing an electronic device 100 according to an embodiment of the present disclosure. FIG. 17 is a view illustrating an example of the electronic device 100 of FIG. 16 implemented as a smartphone.

Referring to FIG. 16, in an embodiment, an electronic device 100 may include a processor 110, a memory device 120, a storage device 130, an input/output device 140, a power supply 150, and a display device 160. In this case, the display device 160 may correspond to any one of the display devices described with reference to FIGS. 3, 11, 12, 13, 14, and 15. The electronic device 100 may further include several ports capable of communicating with a video card, a sound card, a memory card, a USB device, and the like. In an embodiment, the electronic device 100 may be implemented as a television or a home appliance. In another embodiment, as shown in FIG. 17, the electronic device 100 may be implemented as a smartphone. However, the electronic device 100 is not limited thereto, and for example, the electronic device 100 may be implemented as a mobile phone, a video phone, a smart pad, a smart watch, a tablet PC, a vehicle navigation device, a computer monitor, a laptop computer, an entertainment device like a head mounted display (HMD), and the like.

The processor 110 may control the display device 160. The processor 110 may perform certain calculations or tasks. In an embodiment, the processor 110 may be a microprocessor, a central processing unit (CPU), an application processor (AP), and/or the like. The processor 110 may be connected to other components through an address bus, a control bus, a data bus, and the like. The processor 110 may also be connected to an expansion bus, such as a peripheral component interconnect (PCI) bus.

The memory device 120 may store data necessary for the operation of the electronic device 100. For example, the memory device 120 may include an erasable programmable read-only memory (EPROM) device, an electrically erasable programmable read-only memory (EEPROM) device, a flash memory device, a phase change random access memory (PRAM) device, a resistance random access memory (RRAM) device, a nano floating GEe memory (NFGM) device, a polymer random access memory (PoRAM) device, a magnetic random access memory (MRAM) device, a non-volatile memory device such as a ferroelectric random access memory (FRAM) device and/or a volatile memory device such as a dynamic random access memory (DRAM) device, a static random access memory (SRAM) device, and a mobile DRAM device, and the like.

The storage device 130 may include a solid state drive (SSD), a hard disk drive (HDD), a CD-ROM, and the like. The input/output device 140 may include input means such as a keyboard, keypad, touch pad, touch screen, mouse, and the like and output means such as a speaker, a printer, and the like.

The power supply 150 may supply power necessary for the operation of the electronic device 100. The display device 160 may be connected to other components through buses or other communication links. In an embodiment, the display device 160 may be included in the input/output device 140.

In an embodiment, an electronic device includes a display device, and a processor which controls the display device. Here, the display device includes a base substrate including a display area and a peripheral area adjacent to each other, an encapsulation substrate which faces each of the display area and the peripheral area and is coupled to the base substrate at the peripheral area, and on the base substrate, between the base substrate and the encapsulation substrate, each of a first light-emitting element in the display area and including a first light-emitting layer, a second light-emitting element in the display area and including a second light-emitting layer, a dam structure which extends continuously in the peripheral area and includes a first sub-dam and a second sub-dam which overlaps the first sub-dam, the dam structure being spaced apart from the encapsulation substrate, a first light-emitting material layer including the first light-emitting layer and the first sub-dam, a second light-emitting material layer including the second light-emitting layer and the second sub-dam, and a filling layer between the encapsulation substrate, and each of the first light-emitting element and the second light-emitting element, respectively.

A length of the dam structure may be defined extended along the display area. Each of the first sub-dam and the second sub-dam may be disconnected along the length of the dam structure to define a first open portion and a second open portion, respectively. The first open portion and the second open portion may be spaced apart from each other along the length of the dam structure.

Each of the first sub-dam and the second sub-dam may further from the base substrate than each of the first light-emitting material layer and the second light-emitting material layer.

The dam structure including each of the first sub-dam and the second sub-dam may further include an upper surface which is furthest from the base substrate. The upper surface may be further from the base substrate than each of the first light-emitting material layer and the second light-emitting material layer.

An encapsulation layer may be between the filling layer, and each of the first light-emitting element and the second light-emitting element, respectively. The encapsulation layer may extend from the first light-emitting element and the second light-emitting element and into the peripheral area to cover the dam structure including each of the first sub-dam and the second sub-dam.

The present disclosure can be applied to various display devices. For example, the present disclosure is applicable to various display devices such as display devices for vehicles, ships and aircraft, portable communication devices, display devices for exhibition or information transmission, medical display devices, and the like.

The foregoing is illustrative of embodiments and is not to be construed as limiting thereof. Although embodiments have been described, those skilled in the art will readily appreciate that many modifications are possible in the embodiments without materially departing from the novel teachings and advantages of the present inventive concept. Accordingly, all such modifications are intended to be included within the scope of the present inventive concept as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

## Claims

1. A display device (DD) comprising:
a base substrate (BSUB) comprising a display area (DA) and a peripheral area (PA) adjacent to each other;
on the base substrate (BSUB), each of:
a first light-emitting element (LED1) in the display area (DA) and including a first light-emitting layer (EL1);
a second light-emitting element (LED2) in the display area (DA) and including a second light-emitting layer (EL2);
a dam structure (DAM) which extends continuously in the peripheral area (PA) and includes a first sub-dam (SDM1) and a second sub-dam (SDM2) which is on the first sub-dam (SDM1);
a first light-emitting material layer including the first light-emitting layer (EL1) and the first sub-dam (SDM1); and
a second light-emitting material layer including the second light-emitting layer (EL2) and the second sub-dam (SDM2);
an encapsulation substrate (ESUB) facing the base substrate (BSUB) with each of the first light-emitting element (LED1), the second light-emitting element (LED2) and the dam structure (DAM) therebetween; and
a filling layer (FM) between the encapsulation substrate (ESUB), and each of the first light-emitting element (LED1) and the second light-emitting element (LED2), respectively.

2. The display device (DD) of claim 1, wherein
each of the first light-emitting layer (EL1) and the first sub-dam (SDM1) includes a first light-emitting material which emits a light of a first color, and
each of the second light-emitting layer (EL2) and the second sub-dam (SDM2) includes a second light-emitting material which emits a light of a second color different from the first color.

3. The display device (DD) of claim 1 or claim 2, wherein the first sub-dam (SDM1) and the second sub-dam (SDM2) overlap in a plan view.

4. The display device (DD) of any one of claims 1 to 3, wherein the second sub-dam (SDM2) is directly on the first sub-dam (SDM1).

5. The display device (DD) of any one of claims 1 to 4, wherein the dam structure (DAM) surrounds the display area (DA) in a plan view.

6. The display device (DD) of any one of claims 1 to 5, wherein
a length of the dam structure (DAM) is defined extended along the display area (DA),
the first sub-dam (SDM1) is disconnected along the length of the dam structure (DAM) to define a first open portion (OPP1) of the first sub-dam (SDM1), and
the second sub-dam (SDM2) is disconnected along the length of the dam structure (DAM) to define a second open portion (OPP2) of the second sub-dam (SDM2).

7. The display device (DD) of claim 6, wherein:
(i) the first open portion (OPP1) and the second open portion (OPP2) are spaced apart from each other along the length of the dam structure (DAM); and/or
(ii) the second open portion (OPP2) exposes the first sub-dam (SDM1) to outside the second sub-dam (SDM2); and/or
(iii) the second sub-dam (SDM2) extends into the first open portion (OPP1) and includes a connection portion (CNP1) extended across the first open portion (OPP1).

8. The display device (DD) of any one of claims 1 to 7, wherein
a thickness of the first sub-dam (SDM1) is the same as a thickness of the first light-emitting layer (EL1), and
a thickness of the second sub-dam (SDM2) is the same as a thickness of the second light-emitting layer (EL2).

9. The display device (DD) of any one of claims 1 to 8, further comprising:
a sealing member (SM) which is between the base substrate (BSUB) and the encapsulation substrate (ESUB) and couples the base substrate (BSUB) and the encapsulation substrate (ESUB) to each other,
wherein the sealing member (SM) surrounds the dam structure (DAM) in a plan view.

10. The display device (DD) of any one of claims 1 to 9, further comprising, on the base substrate (BSUB), each of:
the first light-emitting element (LED1) further including a first pixel electrode (PE1);
the second light-emitting element (LED2) further including a second pixel electrode (PE2);
an insulating layer (IL4) directly under the first pixel electrode (PE1) and the second pixel electrode (PE2); and
a pixel defining layer (PDL) on the insulating layer (IL4), the first pixel electrode (PE1) and the second pixel electrode (PE2) and defining pixel openings therein which expose the first pixel electrode (PE1) and the second pixel electrode (PE2) to outside the pixel defining layer (PDL), respectively,
wherein the dam structure (DAM) is directly on an upper surface of the insulating layer (IL4) or an upper surface of the pixel defining layer (PDL).

11. The display device (DD) of any one of claims 1 to 10, wherein:
(i) the dam structure (DAM) surrounds the filling layer (FM) in a plan view; and/or
(ii) the filling layer (FM) extends from the first light-emitting element (LED1) and the second light-emitting element (LED2) and covers the dam structure (DAM); and/or
(iii) the encapsulation substrate (ESUB) includes glass.

12. An electronic device (100) comprising:
a display device (160); and
a processor (110) which controls the display device (160),
wherein the display device (160) includes:
a base substrate (BSUB) comprising a display area (DA) and a peripheral area (PA) adjacent to each other;
an encapsulation substrate (ESUB) which faces each of the display area (DA) and the peripheral area (PA) and is coupled to the base substrate (BSUB) at the peripheral area (PA); and
on the base substrate (BSUB), between the base substrate (BSUB) and the encapsulation substrate (ESUB), each of:
a first light-emitting element (LED1) in the display area (DA) and including a first light-emitting layer (EL1);
a second light-emitting element (LED2) in the display area (DA) and including a second light-emitting layer (EL2);
a dam structure (DAM) which extends continuously in the peripheral area (PA) and includes a first sub-dam (SDM1) and a second sub-dam (SDM2) which overlaps the first sub-dam (SDM1), the dam structure (DAM) being spaced apart from the encapsulation substrate (ESUB);
a first light-emitting material layer including the first light-emitting layer (EL1) and the first sub-dam (SDM1);
a second light-emitting material layer including the second light-emitting layer (EL2) and the second sub-dam (SDM2); and
a filling layer (FM) between the encapsulation substrate (ESUB), and each of the first light-emitting element (LED1) and the second light-emitting element (LED2), respectively.

13. The electronic device (100) of claim 12, wherein
a length of the dam structure (DAM) is defined extended along the display area (DA), each of the first sub-dam (SDM1) and the second sub-dam (SMD2) is disconnected along the length of the dam structure (DAM) to define a first open portion (OPP1) and a second open portion (OPP2), respectively, and
the first open portion (OPP1) and the second open portion (OPP2) are spaced apart from each other along the length of the dam structure (DAM).

14. The electronic device (100) of claim 12 or claim 13, wherein:
(i) each of the first sub-dam (SDM1) and the second sub-dam (SDM2) is further from the base substrate (BSUB) than each of the first light-emitting material layer (EL1) and the second light-emitting material layer (EL2); and/or
(ii) the dam structure (DAM) including each of the first sub-dam (SDM1) and the second sub-dam (SDM2) further includes an upper surface which is furthest from the base substrate (BSUB), and
the upper surface is further from the base substrate (BSUB) than each of the first light-emitting material layer (EL1) and the second light-emitting material layer (EL2).

15. The electronic device (100) of any one of claims 12 to 14, further comprising:
the first light-emitting element (LED1) further including a first pixel electrode (PE1) and the first light-emitting layer (EL1);
the second light-emitting element (LED2) further including a second pixel electrode (PE2) and the second light-emitting layer (EL2); and
an encapsulation layer (TFE) between the filling layer (FM), and each of the first light-emitting element (LED1) and the second light-emitting element (LED2), respectively.
wherein encapsulation layer (TFE) extends from the first light-emitting element (LED1) and the second light-emitting element (LED2) and into the peripheral area (PA) to cover the dam structure (DAM) including each of the first sub-dam (SDM1) and the second sub-dam (SDM2).
